# EUROPÄISCHE PATENTSCHRIFT

(11) **EP 0 519 202 B1**
(45) Veröffentlichungstag und Bekanntmachung des Hinweises auf die Patenterteilung: **15.02.1995**
(21) Anmeldenummer: 92107955.4
(22) Anmeldetag: 12.05.1992
(51) Int. Cl.: H05K 7/08, H05K 1/02

(54) **Elektrisches Gerät mit wenigstens einem Kontaktstift und einer Leiterbahnfolie**
Electric device with at least one contact pin and one flexible printed circuit
Dispositif électrique ayant au moins une fiche de contact et un circuit imprimé flexible

(30) Priorität: 08.06.1991 DE 4118936
(43) Veröffentlichungstag der Anmeldung: 23.12.1992
(73) Patentinhaber: ROBERT BOSCH GMBH, 70442 Stuttgart (DE)
(72) Erfinder: Mayer, Rolf, Dipl.-Ing., W-7057 Winnenden-Schelmenholz (DE); Siegel, Heinz, Ing. (grad.), W-7000 Stuttgart 40 (DE); Deringer, Helmut, Dipl.-Ing. (FH), W-7000 Stuttgart 40 (DE); Schurr, Volker, Dipl.-Ing. (FH), W-7141 Schwieberdingen (DE)

(56) Entgegenhaltungen:
- DE-A- 2 841 443
- DE-A- 3 801 352
- DE-A- 3 836 405

## Beschreibung

### Stand der Technik

Die Erfindung geht aus von einem elektrischen Gerät nach der Gattung des Hauptanspruchs.

Durch die DE-OS 38 36 405 ist ein Ventilblock für eine hydraulische Bremsanlage bekannt. Der Ventilblock ist mit einer elastischen Kunststoffspritzgußplatine mit im Heißprägeverfahren aufgebrachten Kupferleiterbahnen zur Kontaktierung von aus Magnetventilspulen herausragenden Spulendrähten ausgestattet. Die Spulendrähte sind durch lochgestanzte Spulendrahtlötstellen der Platine geführt und mit dieser durch Schwallbadlötung verbunden.

Aus Gründen kostengünstiger Fertigung wird angestrebt, Einzelteile mit möglichst großen Toleranzen zu fertigen und zu Baugruppen oder Geräten zu fügen. Schwierigkeiten ergeben sich jedoch, wenn erhebliche Lagetoleranzen aufweisende Kontaktstifte elektrischer Bauteile mit den Lötaugen flexibler Leiterplatten kombiniert werden sollen, weil diese von den Kontaktstiften ausgeübte Kräfte nicht aufnehmen können. Außerdem ist das Lot nicht in der Lage, mehrere Millimeter breite Spalte zwischen Kontaktstift und Lötauge zu überbrücken.

Darüber hinaus nimmt die Festigkeit einer Lötverbindung mit zunehmender Spaltbreite ab.

### Vorteile der Erfindung

Das erfindungsgemäße elektrische Gerät mit dem kennzeichnenden Merkmal des Hauptanspruchs hat demgegenüber den Vorteil, daß auf einfache Weise eine elektrisch sichere, mechanische Verbindung bei Zulassung relativ großer Toleranzen erzielt wird, weil die Schlitze innerhalb des Lötauges liegende, zungenförmige Leiterbahnabschnitte bilden, die bei außermittig das Lötauge durchgreifendem Kontaktstift einerseits dem Stift ausweichen, andererseits aber die Innenfläche des Lötauges weitgehend ausfüllen und als Brücke für das Lot zwischen dem Lötauge und dem Kontaktstift dienen.

Die im Anspruch 2 aufgeführte Maßnahme stellt eine vorteilhafte Weiterbildung des im Hauptanspruch angegebenen elektrischen Gerätes dar, weil durch den Verlauf der Schlitze und deren Breitenabmessung ein günstiges Verhältnis zwischen der Gestaltung der zungenförmigen Leiterbahnabschnitte, deren Flächenanteil im Lötauge und der vom Lot zu überbrückenden Schlitzbreite gefunden ist.

### Zeichnung

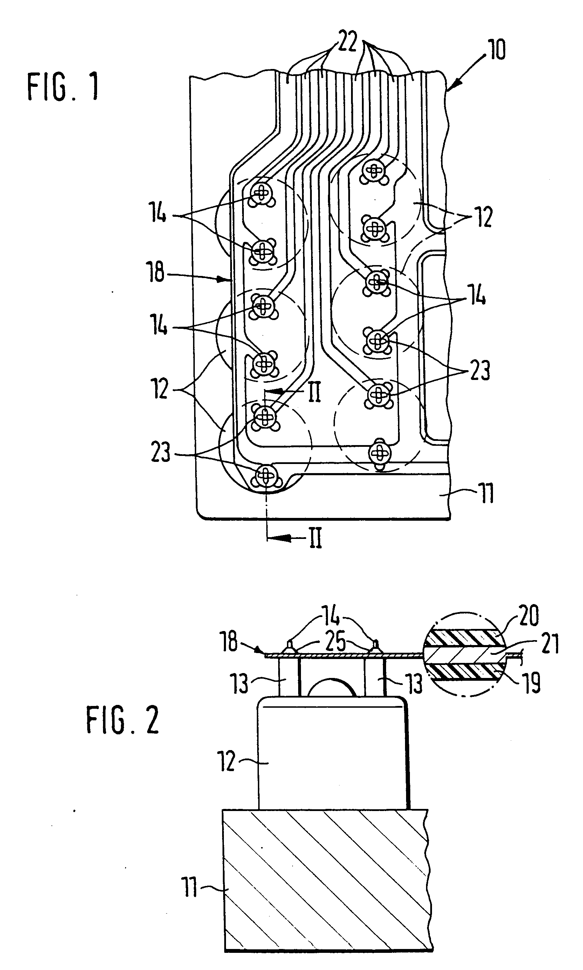

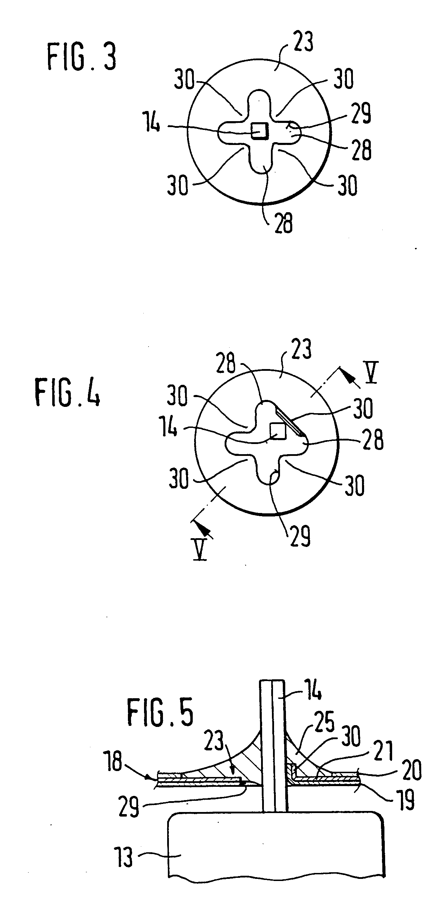

Ein Ausführungsbeispiel der Erfindung ist in der Zeichnung vereinfacht dargestellt und in der nachfolgenden Beschreibung näher erläutert. Es zeigen Figur 1 eine Draufsicht auf einen Abschnitt eines elektrischen Gerätes mit einer von Kontaktstiften durchdrungenen Leiterbahnfolie, Figur 2 einen Schnitt durch das Gerät entlang der Linie II-II in Figur 1 in anderem Maßstab sowie mit vergrößertem Querschnitt der Leiterbahnfolie als Detail, Figur 3 eine Draufsicht auf ein mittig von einem Kontaktstift durchdrungenes Lötauge der Leiterbahnfolie in anderem Maßstab, Figur 4 eine Draufsicht entsprechend Figur 3 mit außermittigem Kontaktstift und Figur 5 einen Querschnitt entlang der Linie V-V in Figur 4 durch eine Lötverbindung zwischen der Leiterbahnfolie und dem Kontaktstift.

### Beschreibung des Ausführungsbeispiels

In den Figuren 1 und 2 ist ein Gerät 10, z. B. ein Ventilblock für eine hydraulische Fahrzeug-Bremsanlage mit Blockierschutz- und Antriebsschlupfregeleinrichtung, dargestellt, welches ein Gehäuse 11 mit mehreren Reihen darin befestigter elektrischer Bauteile 12, z. B. Magnetventile, aufweist. Die nach oben aus dem Gehäuse 11 herausragenden elektrischen Bauteile 12 sind oberseitig mit zwei Stützhülsen 13 versehen, aus denen jeweils ein Kontaktstift 14 mehrere Millimeter lang herausragt. Die Kontaktstifte 14 haben quadratischen Querschnitt mit einer Kantenlänge von weniger als 1 Millimeter. Die sich senkrecht zur Ebene des Gehäuses 11 erstreckenden Kontaktstifte 14 verlaufen parallel zueinander und enden in einer Ebene. Sie sind entsprechend der Anordnung der elektrischen Bauteile 12 ebenfalls in Reihen angeordnet.

Für die Kontaktierung der elektrischen Bauteile 12 ist eine flexible Leiterbahnfolie 18 vorgesehen. Wie das Detail in Figur 2 erkennen läßt, ist die Leiterbahnfolie 18 aus einer unteren Isolierschicht 19 und einer oberen Isolierschicht 20 mit einer dazwischenliegenden Leitschicht 21 aufgebaut. Die eine Verbindung zwischen den einzelnen Schichten herstellende Kleberschicht ist dabei vernachlässigt. Die beiden Isolierschichten 19 und 20 bestehen aus einem hochwärmebeständigen Kunststoff, z. B. Polyimid. Die Leitschicht 21 besteht aus Kupfer. Die gesamte Dicke der Leiterbahnfolie 18 beträgt etwa ein Zehntel Millimeter. Die Leitschicht 21 ist zu Leiterbahnen 22 ausgebildet, welche kontaktstiftseitig in einem Lötauge 23 enden. Ein Lötauge 23 stellt eine kreisförmige Erweiterung der Leiterbahn 22 dar. Im Bereich des Lötauges 23 ist die obere Isolierschicht 20 in einer Fläche von vier Millimeter Durchmesser entfernt, d. h. im Bereich des Lötauges 23 besteht die Leiterbahnfolie 18 lediglich aus der unteren Isolierschicht 19 und der Leitschicht 21 mit zwischen beiden verlaufender Kleberschicht.

Die Leiterbahnfolie 18 ist auf die Kontaktstifte 14 der elektrischen Bauteile 12 bis zur Anlage an den Stützhülsen 13 aufgesteckt. Die Leiterbahnfolie kann aber auch, wie aus Figur 5 ersichtlich, mit Abstand zu den Stützhülsen 13 angeordnet sein. Die Kontaktstifte 14, welche sich rechtwinklig zur Leiterbahnfolie 18 erstrecken, durchgreifen die Leiterbahnfolie im Bereich der Lötaugen 23. Die Lötaugen 23 der Leiterbahnfolie 18 sind mit den Kontaktstiften 14 der elektrischen Bauteile 12 durch Lot 25 verbunden. Das Lot 25 benetzt den gesamten, von der oberen Isolierschicht 20 freien Bereich der Leitschicht 21 innerhalb des entsprechenden Lötauges 23 sowie den jeweiligen Kontaktstift 14 (Figur 5).

Aus den lediglich die Kreisfläche eines Lötauges 23 wiedergebenden Figuren 3 und 4 ist zu erkennen, daß die Lötaugen jeweils einen durch Schlitze 28 gebildeten Durchbruch 29 für den Durchtritt des zugeordneten Kontaktstiftes 14 haben. Die Schlitze 28 gehen vom Zentrum des Lötauges 23 strahlenförmig aus. Wie dargestellt, können die Schlitze 28 kreuzförmig angeordnet sein. Die Schlitze 28 haben eine Breite, welche höchstens der Diagonalen des quadratischen Querschnitt aufweisenden Kontaktstiftes 14 (oder dem Durchmesser eines Kontaktstiftes mit Kreisquerschnitt) entspricht. Zwischen jeweils zwei Schlitzen 28 sind innerhalb des Lötauges 23 liegende, zungenförmige Leiterbahnabschnitte 30 gebildet. Sie dienen dazu, einerseits Lagetoleranzen des Kontaktstiftes 14 relativ zum Lötauge 23 zuzulassen, andererseits aber die Innenfläche des Lötauges weitgehend auszufüllen und als Brücke für das Lot 25 zwischen dem Lötauge und dem Kontaktstift zu dienen.

In Figur 3 verläuft der Kontaktstift 14 mittig zum Lötauge 23. Die zungenförmigen Leiterbahnabschnitte 30 nehmen daher einen gleichmäßigen Abstand zum Kontaktstift 14 ein. Dieser Abstand ist relativ gering und problemlos vom Lot 25 bei der Herstellung der Lötverbindung zu überbrücken.

Figur 4 stellt eine toleranzbedingte, außermittige Anordnung eines Kontaktstiftes 14 im Durchbruch 29 des Lötauges 23 dar. Da der Kontaktstift 14 in dieser Lage nicht von einem Schlitz 28 des Durchbruchs 29 aufgenommen wird, ist beim Montieren der Leiterbahnfolie 18 einer der zungenförmigen Leiterbahnabschnitte 30 hochgestellt worden. Wie aus Figur 5 ersichtlich, kommt hierdurch die Isolierschicht 19 des Leiterbahnabschnitts 30 zur Anlage am Kontaktstift 14. Außerdem ergibt sich ein etwas vergrößerter Abstand zu den übrigen zungenförmigen Leiterbahnabschnitten 30 des Lötauges 23. Dieser Abstand ist jedoch sehr viel kleiner als ein (beim Stand der Technik praktizierter) kreisförmiger Durchbruch mit einem der Schlitzlänge entsprechenden Durchmesser. Das Lot 25 ist auch bei außermittiger Zuordnung des Kontaktstiftes 14 zum Durchbruch 29 des Lötauges 23 in der Lage, die Schmalseite der am Kontaktstift 14 angreifenden Isolierschicht 19 sowie die Abstände zu den übrigen zungenförmigen Leiterbahnabschnitten 30 zu überbrücken.

## Patentansprüche

1. Elektrisches Gerät (10) mit wenigstens einem Kontaktstift (14), welcher einen Durchbruch (29) eines Lötauges (23) einer Leiterbahnfolie (18) durchgreift und durch Lot (25) mit einer Leitschicht (21) der Leiterbahnfolie verbunden ist, dadurch gekennzeichnet, daß der Durchbruch (29) durch vom Zentrum des Lötauges (23) strahlenförmig ausgehende Schlitze (28) gebildet ist.

2. Elektrisches Gerät nach Anspruch 1, dadurch gekennzeichnet, daß die Schlitze (28) kreuzförmig angeordnet sind und eine Breite aufweisen, welche höchstens der Diagonalen/dem Durchmesser des Kontaktstiftes (14) entspricht.

## Claims

1. Electrical device (10) having at least one contact pin (14), which engages through an aperture (29) of a soldering eye (23) of a flexible printed circuit (18) and is connected to a conductive layer (21) of the flexible printed circuit by means of solder (25), characterized in that the aperture (29) is formed by slots (28) radiating from the centre of the soldering eye (23).

2. Electrical device according to Claim 1, characterized in that the slots (28) are arranged in a cross-shape and have a width which corresponds at a maximum to the diagonals/to the diameter of the contact pin (14).

## Revendications

1. Dispositif électrique (10) ayant au moins une broche de contact (14) traversant un passage (29) d'une pastille de brasure (23) d'un circuit imprimé souple (18) et qui est reliée par la brasure (25) à une couche conductrice (21) du circuit imprimé souple, caractérisé en ce que le passage (29) est formé par des fentes (28), rayonnantes à partir du centre de la pastille de brasure (23).

2. Dispositif électrique selon la revendication 1, caractérisé en ce que les fentes (28) sont cruciformes et ont une largeur qui correspond au maximum à la diagonale ou au diamètre de la broche de contact (14).
